(19) Europäisches Patentamt

European Patent Office

Office européen des brevets

(11) EP 3 717 681 B1

(12) **FASCICULE DE BREVET EUROPEEN**

(45) Date de publication et mention de la délivrance du brevet:
**09.03.2022 Bulletin 2022/10**

(21) Numéro de dépôt: **18833261.3**

(22) Date de dépôt: **27.11.2018**

(51) Classification Internationale des Brevets (IPC):
***C30B 11/00*** *(2006.01)*

(52) Classification Coopérative des Brevets (CPC):
**C30B 11/003;** F28F 2013/008; F28F 2270/00

(86) Numéro de dépôt international:
**PCT/FR2018/052998**

(87) Numéro de publication internationale:
**WO 2019/106281 (06.06.2019 Gazette 2019/23)**

(54) **ÉCHANGEUR THERMIQUE POUR SYSTÈME DE SOLIDIFICATION ET/OU DE CRISTALLISATION OFFRANT UN CONTROLE AMÉLIORÉ POUR LES FAIBLES VALEURS DE FLUX THERMIQUE**

WÄRMETAUSCHER FÜR ERSTARRUNGS- UND/ODER KRISTALLISATIONSSYSTEM FÜR VERBESSERTE STEUERUNG FÜR NIEDRIGE WÄRMEFLUSSWERTE

HEAT EXCHANGER FOR SOLIDIFICATION AND/OR CRYSTALLIZATION SYSTEM PROVIDING IMPROVED CONTROL FOR LOW HEAT FLUX VALUES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2017 FR 1761311**

(43) Date de publication de la demande:
**07.10.2020 Bulletin 2020/41**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **PIHAN, Etienne**
  **73290 La Motte-Servolex (FR)**
• **CHAVRIER, Denis**
  **73170 Yenne (FR)**
• **ROUSSEAU, Sylvain**
  **73290 La Motte-Servolex (FR)**

(74) Mandataire: **Brevalex**
  **95, rue d'Amsterdam**
  **75378 Paris Cedex 8 (FR)**

(56) Documents cités:
WO-A1-2016/156074       DE-A1-102008 029 951
DE-B4-102008 029 951    FR-A1- 2 968 127
FR-A1- 2 979 638

## Description

### DOMAINE TECHNIQUE ET ÉTAT DE LA TECHNIQUE ANTÉRIEURE

La présente invention se rapporte à un échangeur thermique particulièrement adapté pour un système de solidification et/ou de cristallisation et à un système de solidification et/ou de cristallisation comportant au moins un tel échangeur, en particulier de solidification directionnelle de matériaux semi-conducteurs, par exemple pour une utilisation dans le domaine photovoltaïque. En particulier, elle se rapporte à un échangeur thermique tel que défini dans le préambule de la revendication 1, et tel que divulgué dans le document FR 2 968 127.

Dans les procédés de solidification dirigée ou directionnelle en creuset de matériau à haut point de fusion, par exemple supérieur à 1000°C, par exemple dans les procédés d'élaboration des lingots multi-cristallins de silicium photovoltaïque, la solidification dirigée est générée par un refroidissement contrôlé du fond du creuset.

L'échangeur thermique du document FR 2 968 127 comporte une première pièce en liaison thermique avec le creuset, et une deuxième pièce en liaison thermique avec une source froide, les première et deuxièmes pièces sont déplaçables l'une par rapport à l'autre, les première et deuxième pièces comportant des reliefs destinés à coopérer les uns avec les autres. Lorsque les reliefs sont emboîtés les uns dans les autres, les surfaces en regard des faces conductrices sont maximales et l'échange thermique par rayonnement est maximal, et lorsque les première et deuxième pièces sont écartées l'une de l'autre, et que les surfaces en regard des faces conductrices sons minimales, l'échange thermique par rayonnement est minimal.

Les reliefs sont en matériau conducteur thermique. Un isolant thermique est disposé à l'extrémité des reliefs. Ainsi en position écartée, lorsque les matériaux isolants des reliefs des deux pièces sont en regard, le rayonnement thermique est interrompu. Dans cette position, il n'y a pas de rayonnement entre les faces latérales car elles ne sont pas en regard.

Cependant, afin de permettre une interpénétration des reliefs en tenant compte de la dilatation thermique des reliefs et éviter tout risque d'un contact qui pourrait mener à un phénomènes de transferts locaux par conduction pouvant endommager l'échangeur, un jeu mécanique doit être prévu. Or il résulte de la présence de ces jeux l'apparition de flux thermiques non négligeables entre les deux pièces en position écartée, ce qui réduit le pouvoir isolant du dispositif, et en particulier la capacité de régulation dans les basses gammes de flux.

On peut chercher à contrôler le flux thermique extrait du creuset, à basses valeurs de flux, lorsque que l'on souhaite minimiser les gradients de chaleur dans la charge et dans le lingot, par exemple pour réduire des contraintes thermomécaniques. Or, si l'on souhaite utiliser des gammes de flux inférieures au pouvoir isolant maximal de l'échangeur thermique, une difficulté survient. Si une zone de chauffe est intégrée dans le bloc échangeur, on peut compenser les pertes par l'échangeur thermique par un apport thermique fourni par la zone de chauffe. Mais se posent des problèmes de maîtrise de l'homogénéité du flux thermique dans le fond du creuset.

### EXPOSÉ DE L'INVENTION

C'est par conséquent un but de la présente invention d'offrir un échangeur thermique pour un système de solidification et/ou cristallisation permettant un contrôle simple et précis du flux thermique extrait du creuset contenant le matériau à solidifier et/ou cristalliser, notamment un contrôle simple et précis du flux thermique de faible valeur.

Le flux thermique est celui échangé par la face inférieure du bloc échangeur bas.

Par exemple, pour une gamme de température de fonctionnement 800°C - 1414°C, on considère une basse valeur de flux thermique, une valeur de flux thermique inférieure à 40 kW/m$^2$ d'échangeur; de préférence inférieure à 30 kW/m$^2$ d'échangeur.

Le but énoncé ci-dessus est atteint par un échangeur thermique comportant au moins une première pièce en matériau isolant thermique et une deuxième pièce en matériau isolant thermique destinées à être interposées entre une source chaude, par exemple le fond d'un creuset, et une source froide par exemple une boîte à eau.

La position relative entre les première et deuxième pièces est ajustable pour modifier les flux thermiques au moins par rayonnement entre la source chaude et la source froide. Les première et deuxième pièces sont structurées de sorte à former entre elles des chicanes de dimensions modifiables, permettant de moduler le facteur de vue entre la source chaude et la source froide.

L'échangeur thermique forme un diaphragme thermique dont l'ouverture est modifiable en fonction de la distance entre les première et deuxième pièces. Plus les pièces sont proches plus le flux par rayonnement est réduit.

Dans un exemple très avantageux, les chicanes sont formées par la coopération d'une pluralité d'éléments isolants thermiques formant chacune des première et deuxième pièces. Ainsi, en position éloignée, un flux thermique s'établit entre la source chaude et la source froide à travers l'échangeur thermique entre les éléments et, en position rapprochée, le flux thermique par rayonnement est faible du fait de la disposition relative des éléments qui forment des obstacles au rayonnement thermique. Les éléments isolants thermiques de la première pièce sont tels qu'ils sont au moins en partie en regard des éléments isolants thermiques de la deuxième pièce.

Dans un exemple de fonctionnement, en position de flux thermique minimale les éléments ne sont pas en contact entre eux et forment des chicanes pour le rayonnement.

Dans un autre exemple de fonctionnement, les éléments d'une première pièce sont en contact avec les éléments de la deuxième pièce de sorte à former une couche isolante thermique continue entre la source chaude et la source froide.

De manière très avantageuse, les éléments de l'une ou des deux pièces présentent des profils structurés, par exemple étagés, de sorte à former des chicanes de forme plus complexe par interpénétration des éléments en matériau isolant thermique., réduisant encore plus efficacement le facteur de de vue entre la source chaude et la source froide, et permettant une variation encore plus progressive de celui-ci, et donc une modulation encore plus fine du flux thermique. En outre en mettant en œuvre des matériaux isolants type feutre, on peut envisager un frottement entre les portions isolantes thermiques s'interpénétrant.

Contrairement aux échangeurs thermiques de l'état de la technique, le flux thermique minimal est obtenu lorsque les pièces sont rapprochées l'une de l'autre et le flux maximale lorsque les pièces sont éloignées l'une de l'autre.

L'invention permet un contrôle améliorée du flux thermique extrait du creuset, notamment à basses valeurs de flux. En effet, l'invention offre une très bonne isolation thermique et permet une variation progressive du flux, ainsi la modulation des faibles valeurs de flux est facilitée. En outre, l'invention permet de mieux maîtriser l'homogénéité du flux dans le fond du creuset, comparativement à un système mettant en œuvre une zone de chauffe intégrée pour compenser les pertes thermiques. L'invention est alors particulièrement adaptée à la solidification et/ou cristallisation par la reprise de de solidification sur germes via le contrôle de la forme de front. Dans un tel procédé, la fusion est effectuée de manière dirigée du haut vers le bas et la solidification est aussi dirigée du bas vers le haut. Dans les deux cas, un flux axial non nul et régulé est intéressant.

Grâce à l'invention, le problème d'ajustement mécanique entre les pièces de l'échangeur thermique ne se pose plus car, dans le cas d'une interpénétration des première et deuxième pièces, un jeu mécanique important peut être prévu sans gêner la modulation du flux thermique.

L'échangeur thermique peut comporter les blocs échangeurs haut et bas qui forment alors des supports pour les éléments isolants thermiques, ou ne comporter que l'un des blocs échangeurs ou aucun des blocs échangeurs, les éléments isolants thermiques étant alors supportés par une ou des structures porteuses, qui ne sont pas en contact thermique avec la source froide et la source chaude.

L'invention présente en outre l'avantage de pouvoir découpler l'échangeur thermique de la zone de chauffe sole, et/ou de pouvoir découpler l'échangeur thermique de la source froide.

L'échangeur thermique selon l'invention présente en outre l'avantage de pouvoir être facilement monté dans un système de solidification et/ou cristallisation existant, en remplacement d'un échangeur thermique existant.

En outre, lors du rapprochement des pièces, on peut prévoir une compression des portions en matériau isolant thermique sans endommager l'échangeur thermique.

Par ailleurs, l'invention permet de remplacer les portions de matériau isolant thermique en cas d'usure, réduisant sensiblement les coûts d'entretien de l'échangeur

En d'autres termes, on module flux thermique extrait en variant progressivement le facteur de vue entre l'échangeur haut en contact thermique avec le creuset et l'échangeur. Ce facteur optique est maximal lorsque les deux échangeurs sont en position écartée et minimal lorsqu'ils sont en position rapprochée.

La présente invention a alors pour objet un échangeur thermique pour système de solidification et/ou cristallisation, ledit échangeur thermique étant destiné à être disposé entre un creuset formant une source chaude, et une source froide, ledit échangeur thermique comportant une première pièce et une deuxième pièce au moins l'une parmi la première pièce et la deuxième pièce étant mobile le long d'une première direction, de sorte que la distance entre la première pièce et la deuxième pièce varie, des moyens de déplacement de l'une et/ou l'autre des première et deuxième pièces, l'échangeur thermique comportant un premier support et un deuxième support, la première pièce comportant une pluralité de premiers éléments fixés sur le premier support, lesdits premiers éléments étant disposés le long d'un premier plan et à distance les uns des autres, chaque premier élément comportant le long de la première direction une face d'extrémité en contact avec le premier support et une deuxième face d'extrémité opposée à la première face d'extrémité, la deuxième pièce comportant une pluralité de deuxièmes éléments fixés au deuxième support, lesdits deuxièmes éléments étant disposés le long d'un deuxième plan à distance les uns des autres, chaque deuxième élément comportant le long de la première direction une face d'extrémité en contact avec le deuxième support et une deuxième face d'extrémité opposée à la première face d'extrémité, le premier plan et le deuxième plan étant sensiblement parallèles. Les premiers éléments et les deuxièmes éléments sont en un matériau isolant thermique, et dans lequel une partie de la deuxième face d'extrémité d'au moins une partie des premiers éléments est en regard de deux deuxièmes faces d'extrémité des deuxièmes éléments, de sorte que le flux de chaleur entre la première pièce et la deuxième pièce augmente lorsque la distance entre la première pièce et la deuxième pièce augmente.

Dans un exemple de réalisation, la deuxième face d'extrémité de chaque premier élément est en regard des faces d'extrémité de deux deuxièmes éléments.

Dans un autre exemple de réalisation, la deuxième face d'extrémité de chaque deuxième élément est en regard des faces d'extrémité de deux premiers éléments.

Dans un exemple avantageux, chaque premier élément comporte, sur la deuxième face d'extrémité, une saillie se projetant le long de la première direction entre deux deuxièmes éléments et/ou chaque deuxième élément comporte, sur la deuxième face d'extrémité, une saillie se projetant le long de la première direction entre deux premiers éléments.

Dans un exemple, le premier support est un bloc échangeur destiné à être en contact avec la source chaude.

Dans un autre exemple, le premier support est une structure porteuse ajourée, comportant des ouvertures traversantes le long de la première direction. La dimension des deuxièmes saillies le long de la première direction peut alors être choisie supérieure à celle des premiers éléments.

Selon une caractéristique, le deuxième support est un bloc échangeur comportant la source froide.

Dans un autre exemple, le deuxième support est une structure porteuse ajourée comportant des ouvertures traversantes le long de la première direction. La dimension des premières saillies le long de la première direction peut alors être supérieure à celle des deuxièmes éléments.

De manière avantageuse, les moyens de déplacement sont configurés pour que les deuxièmes faces d'extrémité des premiers éléments viennent en appui contre les deuxièmes faces d'extrémité des deuxièmes éléments.

Par exemple, les premiers éléments sont des bandes parallèles et les deuxièmes éléments sont des bandes parallèles, les bandes étant disposées périodiquement selon une période donnée p.

La présente invention a également pour objet un système de solidification et/ou de cristallisation dirigée d'un matériau semi-conducteur comportant un creuset destiné à contenir le ou les matériaux à refroidir, une source froide et un échangeur thermique selon l'invention entre le creuset et la source froide pour réguler le flux de chaleur entre le creuset et la source froide.

La source froide peut par exemple être formée dans une paroi du four et dans lequel la deuxième pièce est à distance de ladite paroi, le système comportant des moyens de protection thermique de ladite paroi.

Le système de solidification et/ou de cristallisation dirigée peut comporter une unité de commande configurée pour envoyer des ordres aux moyens de déplacement de modifier la distance entre les deux pièces de l'échangeur thermique selon des schémas déterminés ou en fonction des informations sur le flux et la température.

Le fonctionnement du système de solidification et/ou de cristallisation dirigée selon l'invention peut comporter l'étape de rapprochement des première et deuxième pièces de l'échangeur thermique pour réduire la valeur du flux thermique extrait du creuset, et/ou l'étape d'éloignement des première et deuxième pièces de l'échangeur thermique pour augmenter la valeur du flux thermique extrait du creuset. L'obtention d'une valeur de flux thermique extrait minimale, les premiers éléments sont en contact avec les deuxièmes éléments.

**BRÈVE DESCRIPTION DES DESSINS**

La présente invention sera mieux comprise sur la base de la description qui va suivre et des dessins en annexe sur lesquels:

- la figure 1A est une représentation schématique d'un système de solidification et/ou de cristallisation comportant un exemple d'échangeur thermique selon l'invention, dans un état de flux thermique maximal,
- la figure 1B est une représentation du système de la figure 1A, dans lequel l'échangeur thermique est dans un état de flux thermique minimal,
- la figure 1C est une vue de détail du système des figures 1A et 1B dans un état intermédiaire entre celui de la figure 1A et celui de la figure 1B,
- la figure 2 est une vue de dessus d'un exemple d'une première pièce de l'échangeur thermique des figures 1A et 1B,
- la figure 3 représentent des vues de dessus d'un autre exemple de première et deuxièmes pièces de l'échangeur thermique des figures 1A et 1B,
- les figures 4A à 4C sont des vues de côtés d'un échangeur thermique selon un autre exemple de réalisation dans trois états de conduction différents,
- la figure 5 est une vue de détail de l'échangeur des figures 4A à 4C,
- la figure 6 est une vue en perspective du bloc échangeur haut de l'échangeur des figures 4A à 4C,
- la figure 7 est une vue en perspective du bloc échangeur bas de l'échangeur des figures 4A à 4C,
- la figure 8 est une vue schématique d'un échangeur thermique selon autre exemple de réalisation,
- la figure 9 est une représentation schématique d'un exemple d'un système de solidification et/ou de cristallisation comportant un échangeur thermique selon un autre exemple de réalisation.
- la figure 10A est une vue de dessus d'un exemple d'une première pièce de l'échangeur de la figure 9,
- la figure 10B est une vue en coupe d'un détail de la figure 10A selon le plan A-A,
- la figure 11 est une représentation schématique d'un exemple d'un système de solidification et/ou cristallisation selon un autre exemple de réalisation,
- la figure 12 est une représentation schématique d'une variante d'une deuxième pièce pouvant être mise en œuvre dans le système de la figure 11,
- la figure 13 est une représentation schématique d'une variante de réalisation de l'échangeur thermique des figures 4A à 4C.

## EXPOSÉ DÉTAILLÉ DE MODES DE RÉALISATION PARTICULIERS

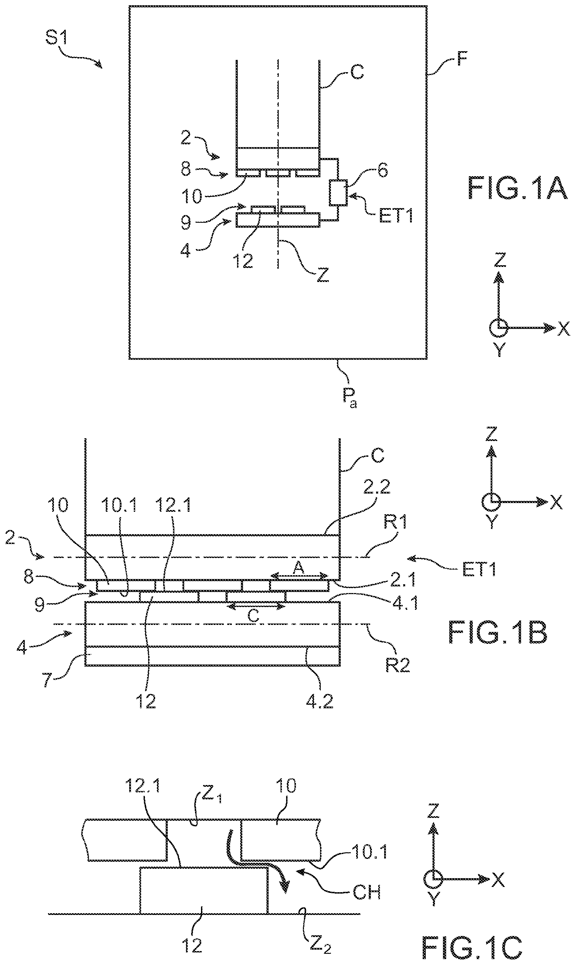

Sur les figures 1A et 1B, on peut voir représenté schématiquement un système de solidification et/ou de cristallisation dirigée S1 comportant un échangeur thermique selon un exemple de réalisation de l'invention, dans deux états de fonctionnement.

Le système de solidification comporte un four F, un creuset C disposé dans le four et un échangeur thermique ET1 disposé entre le creuset et une paroi Pa du four. Dans l'exemple représenté, l'échangeur ET1 est entre le fond du creuset C et la paroi Pa du four.

Le creuset est par exemple chauffé par des résistances en graphite ou par induction électromagnétique sur un élément conducteur, en réalisant un couplage avec une pièce graphite entourant le creuset, ou un couplage avec le silicium liquide contenu dans le creuse.

Le creuset C est destiné à contenir le matériau à solidifier et/ou cristalliser, par exemple du silicium, plus particulièrement pour des applications photovoltaïques.

L'échangeur ET1 comporte un premier bloc échangeur 2 en contact thermique direct avec le fond d'un creuset C, également désigné bloc échangeur haut, et un deuxième bloc échangeur 4 disposé en regard du premier bloc échangeur 2, le deuxième bloc échangeur est désigné bloc échangeur bas. Le premier bloc échangeur 2 possède un plan moyen R1 parallèle au fond du creuset et le deuxième bloc échangeur 4 possède un plan moyen R2 parallèle ou sensiblement parallèle au plan R1.

L'échangeur thermique ET1 est tel que les blocs échangeurs 2 et 4 sont aptes à s'éloigner et à se rapprocher l'une de l'autre le long d'une direction Z orthogonale aux plans R1 et R2, de sorte que leurs plans R1 et R2 restent parallèles ou sensiblement parallèles. Les directions X et Y sont orthogonales à la direction Z et définissent des directions transversales.

Par exemple, l'échangeur comporte des moyens 6 permettant de déplacer le deuxième bloc échangeur 4 le long de la direction Z par rapport au premier bloc échangeur. Les moyens 6 comportent par exemple un groupe motoréducteur actionnant par exemple une vis sans fin reliée à la pièce fixe et un dispositif de contrôle de la distance entre le premier et le deuxième bloc échangeur.

Le bloc échangeur haut 2 comporte une première face 2.1 en regard d'une première face 4.1 du bloc échangeur bas 4. Les faces 2.1 et 4.1 sont parallèles ou sensiblement parallèles.

Le premier bloc échangeur 2 comporte une deuxième face 2.2 orientée vers le fond du creuset. Dans l'exemple représenté, la deuxième face 2.2 est en contact mécanique directement avec le fond du creuset.

Le deuxième bloc échangeur comporte une deuxième face 4.2 opposée à la première face 4.1 et destinée à extraire la chaleur vers une source froide. Dans l'exemple représentée, la deuxième face 4.2 est en contact avec un bloc de cuivre 7 refroidi à l'eau.

L'échangeur thermique ET1 comporte une première pièce 8 et une deuxième pièce 9 en matériau isolant thermique interposées entre le premier 2 et le deuxième 4 bloc échangeur.

Dans l'exemple représenté, la première pièce 8 est fixée sur le bloc échangeur haut 2 et la deuxième pièce 9 est fixée sur le bloc échangeur bas 4.

La première pièce 8 est fixée sur la première face 2.1 du bloc échangeur haut 2 et recouvre partiellement la première face 2.1.

La deuxième pièce 9 est fixée sur la première face 4.1 du bloc échangeur bas 4 et recouvre partiellement la première face 4.1.

Plus particulièrement, les première 8 et deuxième 9 pièces comportent chacune une pluralité d'éléments en matériau isolant thermique distincts les uns des autres, recouvrant les premières faces 2.1 et 4.1, de sorte que des zones Z1, Z2 des premières faces 2.1, 4.1 ne soient pas recouvertes par du matériau isolant thermique. Les éléments isolants thermiques sont entièrement en matériau isolant thermique. Il peut s'agir de un ou plusieurs matériaux, par exemple une superposition de couches.

Dans la suite de la description, le matériau isolant thermique sera désigné isolant thermique ou isolant.

La gamme de température de fonctionnement est définie comme [Tf-600°C; Tf], Tf étant le point de fusion du matériau à fondre/solidifier. Les conductivités thermiques et flux de chaleur donnés ci-dessus sont applicables à cette gamme de température.

Dans la présente demande, on entend par « isolant thermique », un matériau ayant une conductivité thermique inférieure à 5W/m.K, de préférence inférieure à <1W/m.K.

Dans la présente demande, on entend par « conducteur thermique », un matériau ayant une conductivité thermique supérieure à 5 W/m.K, de préférence supérieure à 20 W/m.K.

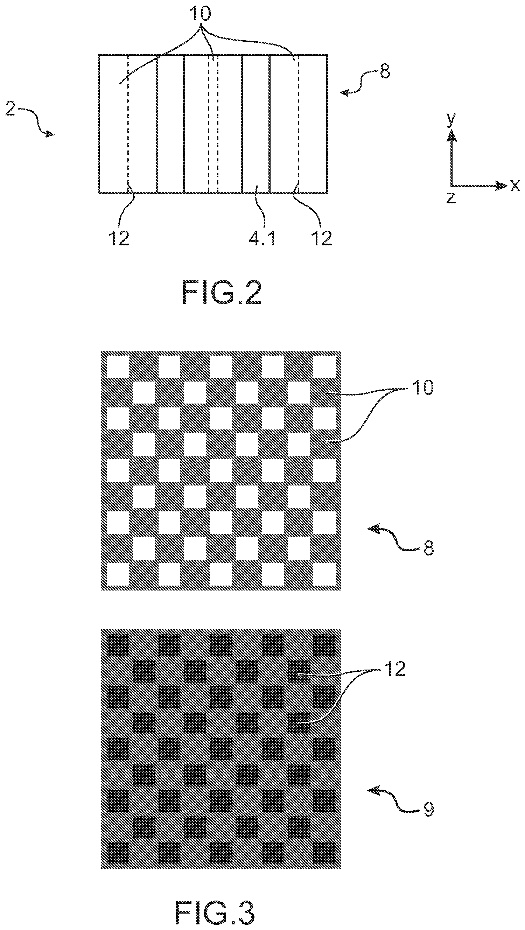

Sur la figure 2, on peut voir une vue de dessus de la première face 2.1 du premier bloc échangeur 2. Les zones recouvertes par les éléments 12 sont représentées en pointillés et sont désignées également 12. Dans cet exemple, les éléments isolants thermiques 10 sont sous forme de bande s'étendant sur toute la largeur du premier bloc échangeur 2 et du deuxième bloc échangeur 4.

Les éléments 10, 12 comportent une face distale 10.1, 12.1 respectivement éloignées de la première 2.1, 4.1 des premier 2 et deuxième 4 blocs échangeurs, et une face proximale orientée vers les blocs échangeurs haut et bas respectivement.

Les dimensions transversales A et C des éléments 10 et 12 respectivement et la distance séparant deux éléments 10 adjacents et deux éléments 12 adjacents sont choisies de sorte que, chaque élément 12 est en partie en regard de deux éléments 10 adjacents et chaque élément 10 est en partie en regard de deux éléments 12 adjacents.

Lorsque les premier 2 et deuxième 4 blocs échangeurs sont en position rapprochée (figure 1B), chaque élément 12 est en appui contre deux éléments 10 adjacents et chaque élément 10 est en appui contre deux éléments 12 adjacents.

Dans l'exemple représenté, les éléments 10 situés au niveau des extrémités transversales de la première face 2.1 ne sont en regard que d'un élément 12.

Les premier et deuxième blocs échangeurs sont en un matériau conducteur thermique, par exemple en graphite. Avantageusement la deuxième pièce est en cuivre et est refroidie par un fluide de refroidissement, tel que l'eau. Les éléments isolants thermiques peuvent être en matériau dense, poreux ou fibreux. Le ou les matériaux isolants thermiques peuvent être carbonés, avantageusement en feutre carbone, également désigné fibres de carbone, qui peut être rigide ou souple. Les feutres de carbone présentent par exemple un taux de carbone >90%. Les matériaux peuvent comporter du SiC. Selon un autre exemple, il peut s'agir de céramiques, par exemple l'alumine, le nitrure de bore, la zircone...

Les éléments isolants thermiques 10, 12 forment des chicanes CH (figure 1C) pour le rayonnement réduisant le facteur de vue entre le bloc échangeur haut et le bloc échangeur bas, notamment les zones Z1 du bloc échangeur haut et les zones Z2 du bloc échangeur bas.

En modifiant la position relative des éléments 10, 12 le long de la direction Z, les dimensions de chicanes varient, ce qui fait varier le facteur de vue entre le bloc échangeur haut et le bloc échangeur bas, ce qui modifie la valeur du flux thermique extrait du creuset.

Dans la présente demande, on entend par « facteur de vue », l'angle solide par lequel la source froide perçoit la source de rayonnement, i.e. la source chaude.

Plus les éléments 10 et 12 sont proches, plus le facteur de vue est faible et plus le flux thermique extrait est faible. Sur la figure 1C, le flux thermique extrait est inférieur à celui dans la position de la figure 1A et est supérieur à celui extrait dans la position de la figure 1B. Plus les éléments 10 et 12 sont éloignés, plus le facteur de vue est grand et plus le flux thermique extrait est élevé (figure 1A).

Dans le mode de fonctionnement représenté sur la figure 1B, les éléments 10 et 12 entrent en contact en position de flux minimal. Une couche continue d'isolant thermique est alors formée entre les premier et deuxième blocs échangeurs thermiques.

Dans un autre mode de fonctionnement, les faces distales de premiers et deuxièmes éléments ne sont pas en contact en position de flux minimal.

Lorsque les éléments isolants thermiques sont en feutre, ils présentent une certaine compressibilité, le contact entre les faces distales des éléments 10 et 12 sur toute la surface des blocs échangeurs est alors assuré même si des variations géométriques existent entre les éléments.

Plus le nombre d'éléments 10 et 12 est grand, plus l'extraction du flux thermique dans les directions X et Y est homogène, assurant une température homogène dans le fond du creuset dans les directions X et Y.

Dans l'exemple de la figure 2, les éléments isolants thermiques 10 et 12 sont en forme de bandes parallèles formant des peignes. Les bandes sont orthogonales à la direction X. Des éléments isolants en bandes inclinées par rapport à X et Y, ou sous forme de bandes courbes, ondulées, en zigzag... ne sortent pas du cadre de la présente invention.

D'autres formes peuvent être envisagées. Dans un autre exemple, les éléments 10 et 12 sont disposés en damier. Dans cet exemple, les éléments 12 présentent une surface plus grande que les zones délimitées entre les éléments 10. Dans un autre mode, la surface des éléments 10 est plus grande que celle des zones délimitées par les éléments 12.

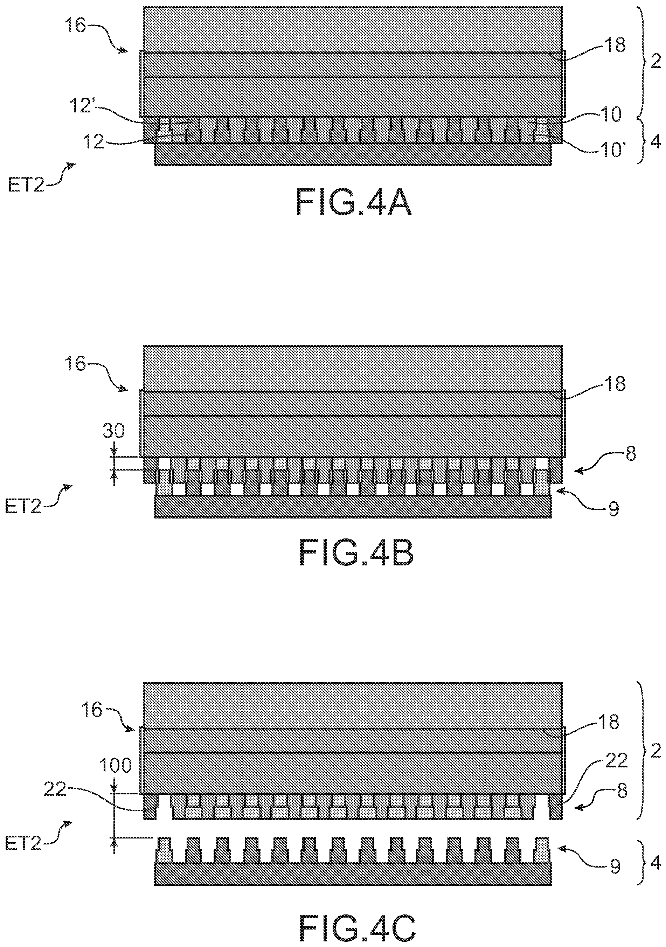

Sur les figures 4A à 4C, on peut voir un autre exemple d'échangeur thermique ET2, dans lequel les éléments isolants s'interpénètrent.

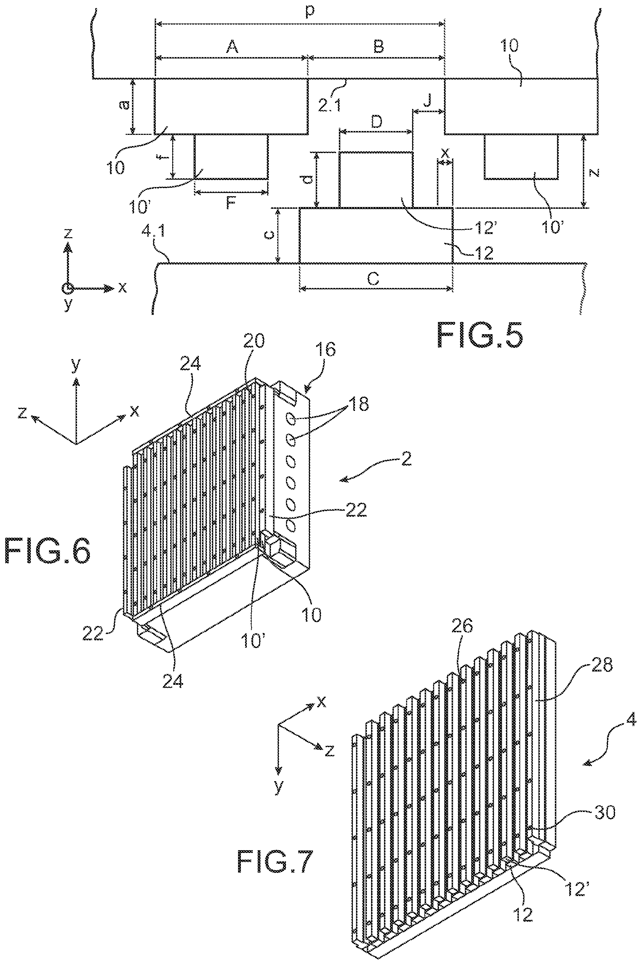

Sur la figure 5, on peut voir une vue de détail de l'échangeur des figures 4A à 4C.

Dans cet exemple les éléments isolants 10, 12 sont prolongés dans la direction Z par des saillies 10', 12' respectivement, également en matériau isolant thermique. Chaque élément et sa saillie sont par exemple réalisés d'un seul tenant.

Les dimensions dans les directions X et Y des saillies 10' sont telles qu'elles pénètrent entre les éléments 12 et les dimensions dans les directions X et Y des saillies 12' sont telles qu'elles pénètrent entre les éléments 10, comme cela est représenté sur la figure 4A.

De préférence, la dimension dans la direction Z de la saillie 12' est inférieure à la dimension de la direction Z des éléments 10 et la dimension dans la direction Z de la saillie 10' est inférieure à la dimension de la direction Z des éléments 12, afin de ne pas gêner le contact entre la face distale des éléments 10 et la face distale des éléments 12. Cependant lorsque les saillies sont en feutre, elles peuvent légèrement se comprimer.

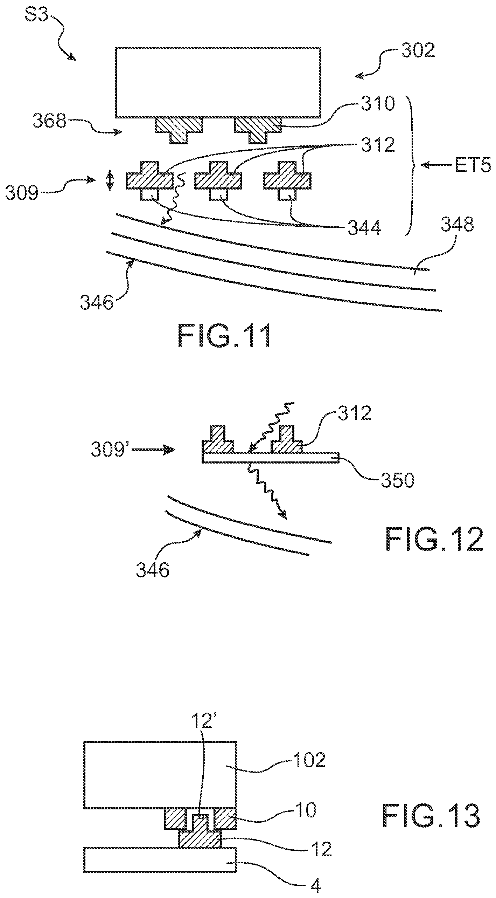

Dans une variante de réalisation, seuls les éléments 12 comportent une saillie 12', comme cela est représenté sur la figure 13. Dans une autre variante seuls les éléments 10 comportent une saillie 10'.

La variante de la figure 13 offre un pouvoir isolant thermique à haute température, i.e. lorsque le rayonnement est prédominant, proche de celui de l'échangeur de figures 4A à 4C lorsque les éléments 10 et les éléments 12 sont en contact. Ce sont alors les bords des faces distales 10.1 des éléments 10 qui entrent en contact avec les bords des faces distales des éléments 12.

Lorsque le fonctionnement prévoit une mise en contact, les éléments isolants sont avantageusement en matériau offrant une certaine compression, par exemple en feutre.

Le choix des dimensions des éléments 10, 12 et des saillies 10', 12' permet de moduler l'amplitude de variation du flux thermique.

Sur la figure 4A, z est égale à 0, les faces d'extrémités des éléments 10 et 12 sont en contact, un flux thermique minimal existe entre le premier bloc échangeur et le deuxième bloc échangeur.

Sur la figure 4B, les pièces sont en partie éloignés, z est égale à 30 mm, les saillies 10', 12' sont interdigitées, un flux thermique de valeur intermédiaire apparaît entre le premier bloc échangeur et le deuxième bloc échangeur. Sur la figure 4C, les pièces sont dans une position d'éloignement maximal (z = 100 mm), le flux thermique est maximal entre le premier et le deuxième bloc échangeur.

L'échangeur thermique des figures 4A à 4C offre une très bonne homogénéité de la valeur du flux extrait sur tout le fond du creuset.

Par exemple, dans le cas d'éléments 10, 12 sous forme de bande, les éléments d'une même pièce ont tous les mêmes dimensions et sont répartis de manière périodique. Pour la première pièce 8, les éléments 10 sont répartis suivant une période p correspondant à la dimension A de l'élément 10 dans la direction X plus la dimension B séparant deux éléments 10 adjacents dans la direction X.

Il est envisageable de réaliser une répartition des éléments 10 et 12 suivant une fréquence variable, par exemple pour extraire un flux thermique différent entre le milieu du creuset et le bord du creuset. Sur la figure 3, dans lequel les éléments 10 et 12 sont répartis en damier, une répartition de pertes thermiques non homogène est aisément réalisable.

Pour la deuxième pièce 9, les éléments 12 sont répartis suivant la période p correspondant à la dimension C de l'élément 12 dans la direction X plus la dimension séparant deux éléments 12 adjacents dans la direction X.

$$p \text{ peut s'écrire } p = A + B = A + C - 2x.$$

Pour les éléments 10, a est la dimension selon Z. f est la dimension selon Z de la saillie 10' et F est la dimension selon X de la saillie 10'.

Pour les éléments 12, c est la dimension selon Z. d est la dimension selon Z de la saillie 12' et D est la dimension selon X de la saillie 12'.

J est la distance entre une face latérale de la saillie 12' et une face latérale en regard de l'élément 10.

x est la dimension selon la direction X de la zone de contact entre une face distale d'un élément 12 et une face distale d'un élément 10.

z est la distance entre une face distale d'un élément 10 et une face distale d'un élément 12.

Dans l'exemple représenté, les deux zones de contact de l'élément 12 avec deux éléments 10 ont la même dimension X. En variante, ces dimensions sont différentes.

Nous allons donner ci-dessous des exemples de dimensions de l'échangeur thermique.

x est par exemple compris entre 1 mm et 10 mm, et est de préférence compris entre 2 mm et 5 mm.

Les dimensions A et C sont par exemple compris entre 15 mm et 100 mm, et de préférence comprises entre 30 mm et 50 mm.

De préférence A et C ont des valeurs proches, de préférence IA-CI < 30 mm, avantageusement inférieur à 10 mm.

Concernant les éléments 12, de préférence la dimension B est proche de la distance séparant deux éléments 12, de préférence la différence entre ces deux dimensions est inférieure à 30 mm, avantageusement inférieure à 10 mm.

La période p est par exemple comprise entre 30 mm et 200 mm, et de préférence entre 50 mm et 90 mm.

Les dimensions a, c et d sont par exemple supérieures à 10 mm. La somme a + b est par exemple comprise entre 20 mm et 250mm, et de préférence comprise entre 40 mm et 80 mm.

La dimension d de la saillie 12' est de l'ordre de la dimension a, et de préférence inférieure à a comme expliqué ci-dessus.

La dimension f est par exemple comprise entre 0 mm et 100 mm.

Le jeu mécanique J est par exemple inférieur ou égal à 20 mm, et préférentiellement entre 1,5 mm et 4 mm Le déplacement z selon la direction entre les deux blocs est par exemple compris entre 0 mm et 2p.

Dans l'exemple représenté, les saillies 10' et 12' sont de forme parallélépipédique et ont une section dans le plan XZ de section rectangulaire.

Les éléments 10, 12 et les saillies 10', 12' peuvent avoir une vue en coupe trapézoïdale, avec une grande base et une petite base de dimensions très proches, par exemple pour un élément ayant une dimension moyenne selon X de 15 mm, la dimension selon X à une position selon Z donnée de l'élément varie a u plus de +/- 5 mm.

En considérant les gammes de dimensions données ci-dessus, dans la position de la figure 4B, z peut être égal à 30 mm et dans la position de la figure 4C, z peut être égal à 100 mm.

La mise en œuvre des saillies 10' et 12' permet de moduler finement l'amplitude de variation de flux en fonction de la distance z.

Sur les figures 6 et 7, on peut voir des vues en perspective du premier bloc échangeur et du deuxième bloc échangeur respectivement.

Dans cet exemple, le premier bloc échangeur présente une plus grande surface que le deuxième bloc échangeur. En outre, dans cet exemple, les angles des échangeurs sont structurés pour le passage de pied support.

Dans cet exemple, le premier bloc échangeur comporte une zone de chauffe 16 comprenant des passages 18 traversant le bloc de part en part dans la direction Y. les passages 18 sont destinés à comporter des barreaux de chauffe (non représentés). Les moyens de chauffage peuvent être omis en fonction des besoins. En l'absence de moyens de chauffage, le bloc échangeur présente une épaisseur sensiblement plus faible, permettant un gain de matière et un gain en temps d'usinage.

Dans cet exemple, chaque élément 10 est fixé sur le premier bloc échangeur 2 au moyen de vis 20 s'étendant dans la direction Z. Les vis sont réparties sur toute la longueur de chaque élément 10. Ce montage permet un remplacement facilité de chaque élément séparément.

Dans cet exemple, les éléments situés aux extrémités du bloc dans la direction X sont désignés 22. Il présente un profil différent des éléments 10 car ils ne sont destinés à n'être en regard que d'un élément 12.

De manière avantageuse, le bloc échangeur comporte des bords isolants thermiques 24 sont disposés de part et d'autre des éléments 10 d'extrémité dans la direction Y, permettant de limiter les pertes thermiques latérales. La mise en œuvre des bords isolants 24 permet de réduire la dissymétrie du flux sur toute la surface du bloc.

Les bords isolants thermiques 22 et 24 sont par exemple également fixés sur le bloc échangeur par des vis. Ils sont par exemple en feutre carboné.

Les bords isolants 22 et 24 forment un cadre bordant la première face 2.1 du premier bloc échangeur 2.

Sur la figure 7, on peut voir une vue en perspective du deuxième bloc échangeur 4.

Les éléments 12 sont également fixés au deuxième bloc échangeur au moyen de vis 26. Les éléments isolants électriques situés aux extrémités du bloc le long de la direction X, sont désignés 28. Ils ont une dimension plus faible que les autres éléments 12 du fait du montage des pieds.

De manière avantageuse, le montage des vis pour fixer les éléments isolants thermiques 10, 12, 22, 24 et 28 est tel que les têtes de vis sont à l'intérieur des éléments isolants et un bouchon, avantageusement isolant thermique recouvre la tête de vis et affleure l'extrémité libres des éléments isolants thermiques.

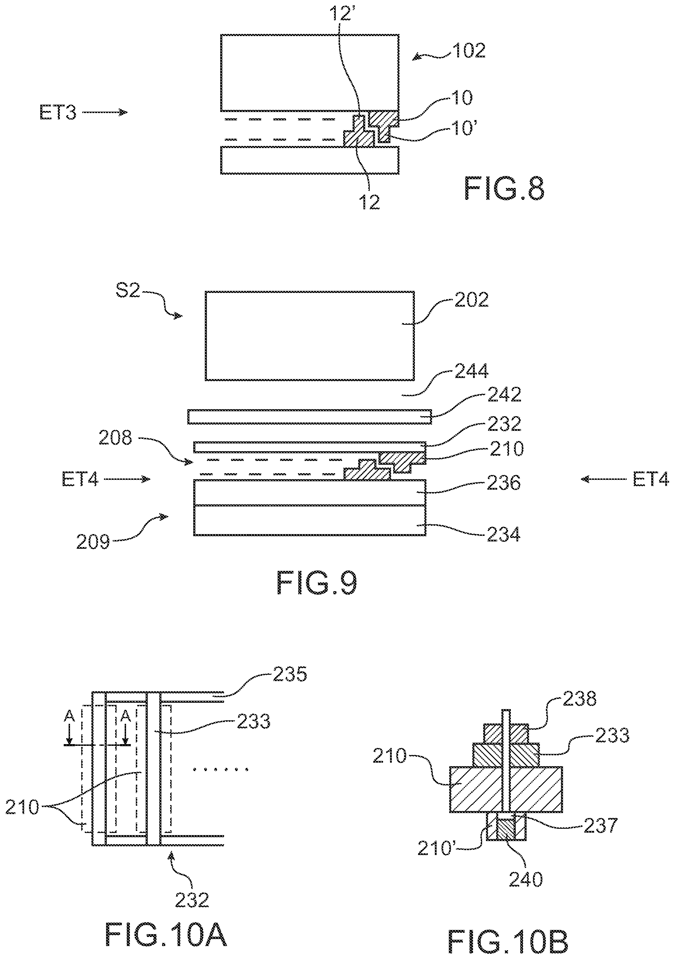

Sur la figure 8, on peut voir un exemple très avantageux d'un échangeur thermique ET3 de la présente invention.

Le premier bloc échangeur 104 ne comporte pas de zone de chauffe sole, le coût de fabrication de l'échangeur est donc réduit. Le deuxième bloc échangeur 4 est similaire à celui de l'échangeur ET1.

Les éléments isolants thermiques 10 et 12 sont similaires à ceux de l'échangeur ET2 et comportent de saillies 10', 12'. Ils pourraient être similaires à ceux de l'échangeur ET1.

La suppression de la zone de chauffe sole est rendue possible par le pouvoir isolant thermique augmenté obtenu grâce à l'échangeur thermique selon l'invention. Du fait des faibles valeurs de flux thermiques atteignables, il peut ne plus être nécessaire de devoir fournir un apport de chaleur pour compenser les pertes thermiques.

Sur la figure 9, on peut voir un autre exemple de réalisation d'un système de solidification S2 comportant un échangeur thermique ET4 selon un autre exemple de réalisation.

Le système de solidification comporte un bloc échangeur haut, un bloc échangeur bas et un échangeur thermique ET4, dont la première pièce 208 n'est pas fixée sur le bloc échangeur haut. Il comporte des éléments isolants 210 et une structure porteuse 232 supportant les éléments isolants 210. La première pièce 208 diffère de la pièce 8, en ce que les éléments isolants 210 ne sont pas fixés sur le bloc échangeur haut. Les éléments isolants 210 sont interposés entre le bloc échangeur bas 204 et le bloc échangeur haut 202 et sont mobiles verticalement entre les deux blocs échangeurs.

Sur les figures 10A et 10B, on peut voir un exemple de réalisation d'une structure porteuse.

La structure porteuse est ajourée. Elle comporte des barreaux 233 sur lesquels sont fixés les éléments isolants et des barreaux transversaux 235 destinés à relier entre eux les barreaux 233 et à former un ensemble rigide. Les barreaux 233 et 235 sont par exemple en graphite ou en composite fibres de carbone / carbone également désigné CFC. La structure porteuse 232 présente une structure offrant une rigidité suffisante pour assurer l'homogénéité du positionnement relatif des deux pièces, i.e. sur toute la surface de l'échangeur.

Sur la figure 10B, on peut voir un détail de fixation d'un élément isolant 210 sur un barreau 235 (vue en coupe selon le plan A-A). Dans l'exemple représenté, une vis 237 et un écrou 238 sont mis en œuvre. Avantageusement la tête de la vis est logée dans une cavité ménagée dans la saillie 210' et un bouchon 240, de préférence en matériau isolant thermique ferme la cavité en recouvrant la tête de la vis.

Dans le cas de blocs échangeur de petites surface, par exemple de surface inférieure à $50 \times 50 cm^2$, on peut envisager de réaliser dans le même matériau les éléments 210 et la structure porteuse, par exemple en feutre carbone rigide.

Dans cet exemple, la zone de chauffe sole 242 est située à distance du bloc échangeur haut et est séparée de celui-ci par une couche de gaz 244, par exemple de l'Argon. La première pièce 202 est également disposée à distance de la zone sole.

Dans cet exemple, les éléments isolants 212 sont fixés sur le bloc échangeur bas 204.

De manière avantageuse, le bloc échangeur bas comporte une partie refroidie à l'eau 234, par exemple en cuivre et une partie formant corps noir 236 interposée entre le cuivre et les éléments isolants 212. La partie formant corps noir 236 est par exemple en graphite.

Une telle réalisation du bloc échangeur bas présente l'avantage de mieux maîtriser le rayonnement vers le corps noir que vers le cuivre directement. En outre, le cuivre est protégé.

Dans une variante, les éléments isolants 212 sont également indépendants du bloc échangeur bas.

L'ouverture optique entre les première et deuxième pièces régule l'extraction de la chaleur du bloc échangeur haut vers le bloc échangeur bas.

L'ouverture optique peut avantageusement être commandée par le déplacement uniquement de la première pièce, i.e. de la structure porteuse, ce qui signifie qu'une masse plus faible est à déplacer, réduisant les contraintes sur l'actionneur.

En outre, le bloc échangeur bas peut ne plus être mobile ce qui simplifie la réalisation de l'échangeur. En effet le bloc échangeur bas est refroidi à l'eau, il requiert une connexion fluidique permanente, rendant plus complexe le déplacement du bloc échangeur bas.

Le coût de construction de l'installation est alors réduit.

Sur la figure 11, on peut voir un autre exemple de système de solidification S3.

Dans cet exemple, la deuxième pièce 309 est indépendante du bloc échangeur bas.

Comme pour l'échangeur de la figure 9 et 10A, la deuxième pièce comporte une structure porteuse 344 et des éléments isolants 312.

Dans cet exemple, les éléments isolants 310 sont fixés directement sur le bloc échangeur haut.

La structure porteuse et la fixation des éléments isolants 312 sont par exemple similaires à celles décrites en relation avec les figures 10A et 10B.

Dans cet exemple, la source froide est formée directement par une partie 346 de la paroi du four refroidie à l'eau. La partie de la paroi 346 est à double paroi, de l'eau ou un autre caloporteur circule à l'intérieur de la double paroi et extrait la chaleur.

La partie 346 est située à l'opposé du bloc échangeur haut 302 par rapport à l'échangeur thermique ET5. La distance entre les deux pièces 308, 309 module l'ouverture optique et le rayonnement du bloc échangeur haut 302 vers la source froide 346.

De manière avantageuse, des moyens de protection 348 sont disposés sur au moins la partie 346 de la paroi entre l'échangeur et la paroi. Les moyens de protection 348 assurent une barrière entre l'échangeur et une fuite de silicium liquide ils comportent une couche de matériau protecteur, par exemple en cuivre, alumine sous forme de mousse, une couche de feutre carbone, une couche de graphite ou une couche de gros grains. La protection peut partiellement ou totalement recouvrir cette surface

De manière préférée, c'est la deuxième pièce qui est déplacée et qui assure le réglage de l'ouverture optique entre le bloc échangeur haut et la source froide.

Cet exemple de réalisation présente l'avantage de ne pas avoir de bloc de cuivre refroidi à l'eau mobile, ce qui simplifie la réalisation de l'échangeur. Le déplacement de la structure porteuse et des éléments isolants 312 est relativement simple, et la masse à déplacer est relativement réduite et ne nécessite pas de gérer des connexions fluidiques.

Sur la figure 12, on peut voir une variante de réalisation de la deuxième pièce 309' par rapport à la pièce 309, dans laquelle la structure porteuse est formée par une plaque pleine 350, avantageusement en graphite, et non par des barreaux.

D'une part la plaque 350 présente une structure de réalisation plus simple que celle du support ajourée. En outre, il peut former des moyens de protection formant une barrière pour le silicium liquide. De préférence la plaque 350 est en graphite peu poreux capable de contenir le silicium liquide.

En variante, des échangeurs ET4 et ET5 dans lesquels les blocs échangeurs bas et le bloc échangeurs haut sont mobiles et les pièces avec les structures porteuses légères sont fixes ne sortent pas du cadre de la présente invention.

Les exemples de réalisation des figures 9 et 11 peuvent être combinés. L'échangeur peut comporter des première et deuxième pièces comportant une structure porteuse « légère » et des éléments isolants, indépendant des blocs échangeurs haut et bas.

Des exemples de réalisation dans lesquels les éléments isolants 10 et/ou 12 sont portés par une structure porteuse ajourée telle que celle représentée sur la figure 10A, on peut prévoir que les saillies 10' aient une dimension dans la direction Z supérieure à celle des éléments 12 et/ou les saillies 12' aient une dimensions dans la direction Z supérieure à celle des éléments 10. Le flux de chaleur extrait est alors contrôlable plus aisément. Dans cette réalisation, les moyens de déplacement sont tels qu'ils assurent une plus grande amplitude de déplacement entre les deux pièces, ce qui permet d'atteindre des flux de valeur augmentée.

Le système de solidification et/ou cristallisation comporte avantageusement une unité de commande commandant les moyens de déplacement pour modifier la distance entre les première et deuxième pièce de l'échangeur thermique de manière automatiques et suivant un ou des schémas déterminés, par exemple suivant le matériau à solidifier et/ou à cristalliser et le type de structure à obtenir.

L'avancement de la solidification pendant le procédé, par exemple par palpage mécanique du front solide/liquide peut être suivi pour ajuster les températures et flux extraits en général de manière empirique.

**Revendications**

1. Echangeur thermique pour système de solidification et/ou cristallisation, ledit échangeur thermique étant destiné à être disposé entre un creuset formant une source chaude, et une source froide, ledit échangeur thermique comportant une première pièce (8) et une deuxième pièce (9), au moins l'une parmi la première pièce (8) et la deuxième pièce (9) étant mobile le long d'une première direction (Z), de sorte que la distance entre la première pièce (8) et la deuxième pièce (9) varie, des moyens de déplacement (12) de l'une et/ou l'autre des première (8) et deuxième (9) pièces, l'échangeur thermique comportant un premier support et un deuxième support, la première pièce (8) comportant une pluralité de premiers éléments (10) fixés sur le premier support, lesdits premiers éléments (10) étant disposés le long d'un premier plan et à distance les uns des autres, chaque premier élément (10) comportant le long de la première direction une face d'extrémité en contact avec le premier support et une deuxième face d'extrémité (10.2) opposée à la première face d'extrémité, la deuxième pièce comportant une pluralité de deuxièmes éléments (12) fixés au deuxième support, lesdits deuxièmes éléments (12) étant disposés le long d'un deuxième plan à distance les uns des autres, chaque deuxième élément (12) comportant le long de la première direction une face d'extrémité en contact avec le deuxième support et une deuxième face d'extrémité (12.1) opposée à la première face d'extrémité, le premier plan et le deuxième plan étant sensiblement parallèles, l'échangeur thermique étant **caractérisé en ce que** les premiers éléments (10) et les deuxièmes éléments (12) sont en un matériau isolant thermique, et dans lequel une partie de la deuxième face d'extrémité (10.1) d'au moins une partie des premiers éléments (10) est en regard de deux deuxièmes faces d'extrémité (12.1) des deuxièmes éléments (12), de sorte que le flux de chaleur entre la première pièce et la deuxième pièce augmente lorsque la distance entre la première pièce (8) et la deuxième pièce (9) augmente.

2. Echangeur thermique selon la revendication 1, dans lequel la deuxième face d'extrémité de chaque premier élément est en regard des faces d'extrémité de deux deuxièmes éléments.

3. Echangeur thermique selon la revendication 1, dans lequel la deuxième face d'extrémité de chaque deuxième élément est en regard des faces d'extrémité de deux premiers éléments.

4. Echangeur thermique selon la revendication 1, 2 ou 3, dans lequel chaque premier élément (10) comporte, sur la deuxième face d'extrémité, une première saillie (10') se projetant le long de la première direction (Z) entre deux deuxièmes éléments (12) et/ou chaque deuxième élément (12) comporte, sur la deuxième face d'extrémité, une deuxième saillie (12') se projetant le long de la première direction (Z) entre deux premiers éléments (10).

5. Echangeur thermique selon l'une des revendications 1 à 4, dans lequel le premier support est un bloc échangeur destiné à être en contact avec la source chaude.

6. Echangeur thermique selon l'une des revendications 1 à 4, dans lequel le premier support est une structure porteuse ajourée, comportant des ouvertures traversantes le long de la première direction (Z).

7. Echangeur thermique selon l'une des revendications 1 à 6, dans lequel le deuxième support est un bloc échangeur comportant la source froide.

8. Echangeur thermique selon les revendications 4 et 6, dans lequel la dimension des deuxièmes saillies (12') le long de la première direction (Z) est supérieure à celle des premiers éléments (10).

9. Echangeur thermique selon l'une des revendications 1 à 6 et 8, dans le deuxième support est une structure porteuse ajourée comportant des ouvertures traversantes le long de la première direction.

10. Echangeur thermique selon les revendications 4 et 9, dans lequel la dimension des premières saillies (10') le long de la première direction (Z) est supérieure à celle des deuxièmes éléments (12).

11. Echangeur thermique selon l'une des revendications 1 à 10, dans lequel les moyens de déplacement sont configurés pour que les deuxièmes faces d'extrémité des premiers éléments (10) viennent en appui contre les deuxièmes faces d'extrémité des deuxièmes éléments (12).

12. Echangeur thermique selon l'une des revendications 1 à 11, dans lequel les premiers éléments (10) sont des bandes parallèles et les deuxièmes éléments (12) sont des bandes parallèles, les bandes étant disposées périodiquement selon une période donnée p.

13. Système de solidification et/ou de cristallisation dirigée d'un matériau semi-conducteur comportant un creuset destiné à contenir le ou les matériaux à refroidir, une source froide et un échangeur thermique selon l'une des revendications précédentes entre le creuset et la source froide pour réguler le flux de chaleur entre le creuset et la source froide.

14. Système de solidification et/ou de cristallisation dirigée selon la revendication 13, dans lequel la source froide est formée dans une paroi du four et dans lequel la deuxième pièce est à distance de ladite paroi, le système comportant des moyens de protection thermique de ladite paroi.

**15.** Système de solidification et/ou de cristallisation dirigée selon la revendication 13 ou 14, comportant une unité de commande configurée pour envoyer des ordres aux moyens de déplacement de modifier la distance entre les deux pièces de l'échangeur thermique selon des schémas déterminés ou en fonction des informations sur le flux et la température.

**Patentansprüche**

**1.** Wärmetauscher für ein Erstarrungs- und/oder Kristallisationssystem, wobei der Wärmetauscher dazu bestimmt ist, zwischen einem Tiegel, der eine heiße Quelle bildet, und einer kalten Quelle angeordnet zu werden, wobei der Wärmetauscher ein erstes Teil (8) und ein zweites Teil (9) enthält, wobei zumindest eines aus erstem Teil (8) und zweitem Teil (9) entlang einer ersten Richtung (Z) beweglich ist, so dass der Abstand zwischen dem ersten Teil (8) und dem zweiten Teil (9) variiert, sowie Mittel (12) zum Verlagern des einen und/oder des anderen aus erstem (8) und zweitem (9) Teil, wobei der Wärmetauscher einen ersten Träger und einen zweiten Träger enthält, wobei das erste Teil (8) eine Vielzahl von ersten Elementen (10) enthält, die an dem ersten Träger befestigt sind, wobei die ersten Elemente (10) entlang einer ersten Ebene und in einem Abstand voneinander angeordnet sind, wobei jedes erste Element (10) entlang der ersten Richtung eine Endfläche, die in Kontakt mit dem ersten Träger ist, und eine der ersten Endfläche entgegengesetzte zweite Endfläche (10.2) aufweist, wobei das zweite Teil eine Vielzahl von zweiten Elementen (12) enthält, die an dem zweiten Träger befestigt sind, wobei die zweiten Elemente (12) entlang einer zweiten Ebene in einem Abstand voneinander angeordnet sind, wobei jedes zweite Element (12) entlang der ersten Richtung eine Endfläche in Kontakt mit dem zweiten Träger und eine der ersten Endfläche entgegengesetzte zweite Endfläche (12.1) aufweist, wobei die erste Ebene und die zweite Ebene im Wesentlichen parallel verlaufen, wobei der Wärmetauscher **dadurch gekennzeichnet ist, dass** die ersten Elemente (10) und die zweiten Elemente (12) aus einem wärmeisolierenden Material bestehen und wobei ein Abschnitt der zweiten Endfläche (10.1) zumindest eines Teils der ersten Elemente (10) zwei zweiten Endflächen (12.1) der zweiten Elemente (12) gegenüberstehen, so dass der Wärmefluss zwischen dem ersten Teil und dem zweiten Teil zunimmt, wenn der Abstand zwischen dem ersten Teil (8) und dem zweiten Teil (9) zunimmt.

**2.** Wärmetauscher nach Anspruch 1 , wobei die zweite Endfläche jedes ersten Elements den Endflächen von zwei zweiten Elementen gegenüberliegt.

**3.** Wärmetauscher nach Anspruch 1, wobei die zweite Endfläche jedes zweiten Elements den Endflächen von zwei ersten Elementen gegenüberliegt.

**4.** Wärmetauscher nach Anspruch 1, 2 oder 3, wobei jedes erste Element (10) an der zweiten Endfläche einen ersten Vorsprung (10') aufweist, der entlang der ersten Richtung (Z) zwischen zwei zweiten Elementen (12) vorspringt und/oder jedes zweite Element (12) an der zweiten Endfläche einen zweiten Vorsprung (12') aufweist, der entlang der ersten Richtung (Z) zwischen zwei ersten Elementen (10) vorspringt.

**5.** Wärmetauscher nach einem der Ansprüche 1 bis 4, wobei der erste Träger ein Tauscherblock ist, der dazu bestimmt ist, mit der heißen Quelle in Kontakt zu stehen.

**6.** Wärmetauscher nach einem der Ansprüche 1 bis 4, wobei der erste Träger eine durchbrochene Stützstruktur ist, die Durchgangsöffnungen entlang der ersten Richtung (Z) aufweist.

**7.** Wärmetauscher nach einem der Ansprüche 1 bis 6, wobei der zweite Träger ein Tauscherblock ist, der die kalte Quelle enthält.

**8.** Wärmetauscher nach einem der Ansprüche 4 und 6, wobei die Abmessung der zweiten Vorsprünge (12') entlang der ersten Richtung (Z) größer ist als die der ersten Elemente (10).

**9.** Wärmetauscher nach einem der Ansprüche 1 bis 6 und 8, wobei der zweite Träger eine durchbrochene Stützstruktur ist, die Durchgangsöffnungen entlang der ersten Richtung aufweist.

**10.** Wärmetauscher nach einem der Ansprüche 4 und 9, wobei die Abmessung der ersten Vorsprünge (10') entlang der ersten Richtung (Z) größer ist als die der zweiten Elemente (12).

**11.** Wärmetauscher nach einem der Ansprüche 1 bis 10, wobei die Verlagerungsmittel so ausgebildet sind, dass die zweiten Endflächen der ersten Elemente (10) in Anlage an die zweiten Endflächen der zweiten Elemente (12) gelangen.

**12.** Wärmetauscher nach einem der Ansprüche 1 bis 11, wobei die ersten Elemente (10) parallele Streifen und die zweiten Elemente (12) parallele Streifen sind, wobei die Streifen periodisch gemäß einer gegebenen Periode p angeordnet sind.

**13.** System zur gerichteten Erstarrung und/oder Kristallisation eines Halbleitermaterials, enthaltend einen Tiegel zur Aufnahme des bzw. der zu kühlenden Materialien, eine kalte Quelle und einen Wärmetauscher nach einem der vorhergehenden Ansprüche zwischen dem Tiegel und der kalten Quelle zur Regelung des Wärmeflusses zwischen dem Tiegel und der kalten Quelle.

14. System zur gerichteten Erstarrung und/oder Kristallisation nach Anspruch 13, wobei die kalte Quelle in einer Wand des Ofens ausgebildet ist und wobei das zweite Teil von der Wand beabstandet ist, wobei das System Mittel zum thermischen Schutz der Wand enthält.

15. System zur gerichteten Erstarrung und/oder Kristallisation nach Anspruch 13 oder 14, enthaltend eine Steuereinheit, die dazu ausgelegt ist, Befehle an die Verlagerungsmittel zu senden, um den Abstand zwischen den beiden Teilen des Wärmetauschers nach bestimmten Mustern oder in Abhängigkeit von Strömungs- und Temperaturinformationen zu ändern.

**Claims**

1. A heat exchanger for a solidification and/or crystallization system, said heat exchanger being intended to be disposed between a crucible forming a hot source, and a cold source, said heat exchanger including a first part (8) and a second part (9), at least one of the first part (8) and the second part (9) being movable along a first direction (Z), such that the distance between the first part (8) and the second part (9) varies, means (12) for displacing one and/or the other of the first (8) and second (9) parts, the heat exchanger including a first support and a second support, the first part (8) including a plurality of first elements (10) fastened on the first support, said first elements (10) being disposed along a first plane and at a distance from each other, each first element (10) including, along the first direction, an end face in contact with the first support and a second end face (10.2) opposite to the first end face, the second part including a plurality of second elements (12) fastened to the second support, said second elements (12) being disposed along a second plane at a distance from each other, each second element (12) including, along the first direction, an end face in contact with the second support and a second end face (12.1) opposite to the first end face , the first plane and the second plane being substantially parallel, the heat exchanger being **characterised in that** the first elements (10) and the second elements (12) are made of a thermal insulating material, and wherein one portion of the second end face (10.1) of at least one portion of the first elements (10) is opposite to two second end faces (12.1) of the second elements (12), such that the heat flux between the first part and the second part increases when the distance between the first part (8) and the second part (9) increases.

2. The heat exchanger according to claim 1, wherein the second end face of each first element is opposite to the end faces of two second elements.

3. The heat exchanger according to claim 1, wherein the second end face of each second element is opposite to the end faces of two first elements.

4. The heat exchanger according to claim 1, 2 or 3, wherein each first element (10) includes, on the second end face, a first protrusion (10') projecting along the first direction (Z) between two second elements (12) and/or each second element (12) includes, on the second end face, a second protrusion (12') projecting along the first direction (Z) between two first elements (10).

5. The heat exchanger according to one of claims 1 to 4, wherein the first support is an exchanger block intended to be in contact with the hot source.

6. The heat exchanger according to one of claims 1 to 4, wherein the first support is an openwork support structure, including through openings along the first direction (Z).

7. The heat exchanger according to one of claims 1 to 6, wherein the second support is an exchanger block including the cold source.

8. The heat exchanger according to claims 4 and 6, wherein the dimension of the second protrusions (12') along the first direction (Z) is greater than that of the first elements (10).

9. The heat exchanger according to one of claims 1 to 6 and 8, in the second support is an openwork support structure including through openings along the first direction.

10. The heat exchanger according to claims 4 and 9, wherein the dimension of the first protrusions (10') along the first direction (Z) is greater than that of the second elements (12).

11. The heat exchanger according to one of claims 1 to 10, wherein the displacement means are configured so that the second end faces of the first elements (10) bear against the second end faces of the second elements (12).

12. The heat exchanger according to one of claims 1 to 11, wherein the first elements (10) are parallel strips and the second elements (12) are parallel strips, the bands being periodically disposed according to a given period p.

13. A system for directed solidification and/or crystallization of a semiconductor material including a crucible intended to contain the material(s) to be cooled, a cold source and a heat exchanger according to one of the preceding claims between the crucible and the cold source to regulate the heat flux between the crucible and the cold source.

14. A directed solidification and/or crystallization system according to claim 13, wherein the cold source is formed in a wall of the furnace and wherein the second part is at a distance from said wall, the system including means for thermal protection of said wall.

15. The directed solidification and/or crystallization system according to claim 13 or 14, including a control unit configured to send orders to the displacement means to change the distance between the two parts of the heat exchanger according to determined patterns or depending on flux and temperature information.

FIG.1A

FIG.1B

FIG.1C

FIG.2

FIG.3

FIG.4A

FIG.4B

FIG.4C

FIG.5

FIG.6

FIG.7

FIG.8

FIG.9

FIG.10A

FIG.10B

S3

368

309

302

310

312

ET5

344

348

346

**FIG.11**

309'

312

350

346

**FIG.12**

12'

102

10

12

4

**FIG.13**

**EP 3 717 681 B1**

**RÉFÉRENCES CITÉES DANS LA DESCRIPTION**

**Documents brevets cités dans la description**

- FR 2968127